**Europäisches Patentamt**

**European Patent Office**

**Office européen des brevets**

(19)

(11) Veröffentlichungsnummer: **0 078 338**
**B1**

(12) **EUROPÄISCHE PATENTSCHRIFT**

(45) Veröffentlichungstag der Patentschrift:
**05.02.86**

(51) Int. Cl.⁴: **G 11 C 11/24**

(21) Anmeldenummer: **81109372.3**

(22) Anmeldetag: **30.10.81**

(54) **FET-Speicher.**

(43) Veröffentlichungstag der Anmeldung:
**11.05.83 Patentblatt 83/19**

(45) Bekanntmachung des Hinweises auf die Patenterteilung:
**05.02.86 Patentblatt 86/6**

(84) Benannte Vertragsstaaten:
**DE FR GB**

(56) Entgegenhaltungen:
**IBM TECHNICAL DISCLOSURE BULLETIN, Band 23, Nr. 6, November 1980, Seiten 2331-2332, New York, USA L. ARZUBI et al.: "One-device memory cell arrangement with improved sense signals"**

(73) Patentinhaber: **IBM DEUTSCHLAND GMBH, Pascalstrasse 100, D-7000 Stuttgart 80 (DE)**

(84) Benannte Vertragsstaaten: **DE**

(73) Patentinhaber: **International Business Machines Corporation, Old Orchard Road, Armonk, N.Y. 10504 (US)**

(84) Benannte Vertragsstaaten: **FR GB**

(72) Erfinder: **Arzubi, Luis, Taunusstrasse 54, D-7030 Böblingen (DE)**

(74) Vertreter: **Rudolph, Wolfgang, Dipl.-Ing., Schönaicher Strasse 220, D-7030 Böblingen (DE)**

**Beschreibung**

Die Erfindung betrifft einen FET-Speicher nach dem Oberbegriff des Patentanspruchs 1.

Hochintegrierte Speicher mit kapazitiver Speicherung und Feldeffekttransistoren sind grundsätzlich bekannt. So ist z.B. in der DE-A 1 774 482 ein kapazitiver wortorientierter Speicher beschrieben, dessen Speicherzellen aus je einem Feldeffekttransistor und einem Kondensator bestehen, wobei der eine Anschluß des Transistors mit dem Kondensator, der andere Anschluß mit der Bitleitung, die Torelektrode mit der Wortleitung und der Trägerschichtanschluß mit einer Betriebsspannungsquelle verbunden ist. Eine solche Ein-Transistor-Speicherzelle aus Feldeffekttransistoren hat den Vorteil, daß sie eine hohe Integrationsdichte bei einem relativ einfachen Herstellungsprozeß zuläßt.

Der Hauptnachteil dieser Ein-FET-Speicherzelle ist jedoch darin zu sehen, daß das Einschreiben und das Auslesen von Informationen nur relativ langsam abläuft. Außerdem ist das Lesesignal relativ klein und die kapazitive Belastung der Bit- und Wortleitungen relativ groß. Mit der immer weiter zunehmenden Packungsdichte solcher Speicher ergeben sich insofern große Probleme, als das Signal beim Auslesen bzw. beim Abfühlen des Inhalts einer Speicherzelle nicht mehr zuverlässig wahrnehmbar klein wird. Dies erfordert zum einen äußerst komplizierte Abfühlschaltkreise und zum anderen ein sehr genaues Einhalten sowohl der Zeitdauer als auch der Pegel einer ganzen Reihe von aufeinanderfolgenden Steuersignalen. Die Signalfolge für eine Leseoperation ist dabei noch verschieden von der für eine Schreiboperation, so daß viele Hilfsschaltkreise nötig sind, um einen derartigen Speicher überhaupt noch betreiben zu können. Außerdem sinkt die Arbeitsgeschwindigkeit mit abnehmender Größe des abgefühlten Signals.

Um schnellere Schreib- und Lesezyklen zu erreichen, wurden integrierte dynamische Halbleiterspeicher mit Zellen aus zwei Feldeffekttransistoren aufgebaut. Ein derartiger Speicher mit zwei über je einen Feldeffekttransistor zugängigen Speicherkondensatoren ist im IBM Technical Disclosure Bulletin, Vol. 18, Nr. 3, August 1975, Seiten 786 und 787, und durch die DE-C 2 431 079 bekannt geworden. Hiernach ist jede Speicherzelle aus zwei Reihenschaltungen mit je einem Speicherkondensator und einem Schreib-/Lese-Feldeffekttransistor aufgebaut. Diese Reihenschaltungen sind zwischen den Bitleitungen eines Bitleitungspaares und einem gemeinsamen, wechselstrommäßig auf Massepotential liegenden Verbindungspunkt angeordnet. Eine gemeinsame Wortleitung verbindet die Steuerelektroden der beiden Transistoren. Bei einem Auslesen der Information einer adressierten Speicherzelle wird das Differenzsignal auf beiden Bitleitungen zur Verstärkung einer Verriegelungsschaltung zugeführt. Durch diese Schaltungsanordnung wird eine hohe Schreib- und Lesegeschwindigkeit bei jeweils relativ einfacher Steuersignalfolge erzielt. Ein wesentlicher Nachteil ist jedoch die Begrenzung der Speicherzellen pro Bitleitung, da die kapazitive Belastung zu groß wird und damit entweder die Speicherzellengröße, die Leitungsbreite und die Auslegung der Peripherieschaltkreise sich wesentlich vergrößern oder das erzielte Lese signal so klein wird, daß es nicht mehr sicher und mit vertretbarem Aufwand erkannt werden kann.

Zur weiteren Verbesserung der Geschwindigkeit und Vereinfachung der Zeitsteuerung ist in der DE-P 2 712 735 eine frühzeitige Selektion der Bitleitungsschalter, die zur Verbindung von Speicherzellenbereich und Datenein-, ausgabeleitungen erforderlich sind, mit einem niedrigen Steuerimpuls gezeigt, so daß in Abhängigkeit von dem sich entwickelnden, von einer Speicherzelle auf das zugehörige Bitleitungspaar gebrachten und vorzugsweise vorverstärkten Differenzsignal nur für einen der beiden Bitleitungsschalter die Einschaltschwelle überschritten wird, während der Bitleitungsschalter in der anderen Bitleitung gesperrt bleibt und ein Absinken des Potentials dieser Bitleitung und damit des Potentials des damit verbundenen Zellknotens verhindert. Eine weitere Herabsetzung der Zugriffszeit durch Verkürzen der Zeitspanne zur Abfühlung der gespeicherten Größen ist nicht ohne weiteres möglich, da sonst einerseits die Information nicht mehr zuverlässig zu erkennen wäre und andererseits die Geschwindigkeit bei zu starker Verringerung des abgefühlten Signals sowieso niedriger würde. Außerdem ist auch hier wieder die Anzahl der Zellen pro Bitleitung durch die kapazitiven Lasten beschränkt.

Ein 64K-Bit-MOS Dynamic RAM ist in IEEE, Journal of SCC, Seiten 184 bis 189 vom April 1980 unter dem Titel 'A 64 Kilobit Dynamic RAM' von F. Smith et al, beschrieben. Auch dieser Speicher weist wieder den Nachteil auf, daß die Zellen pro Bitleitung durch die kapazitive Belastung beschränkt ist. Wollte man die Speicherzellenanzahl pro Bitleitung wesentlich erhöhen, dann müßte man auch bei diesem Speicher die höheren schädlichen Kapazitäten durch größere Ströme, breitere Leitungsführungen und komplizierte Peripherieschaltkreise kompensieren.

Der Erfindung liegt deshalb die Aufgabe zugrunde, einen Aufbau eines Speichers mit Speicherzellen aus Feldeffekttransistoren anzugeben, bei dem die Speicherzellenanzahl pro Bitleitung und damit verbundener Verriegelungsschaltung um das Doppelte erhöht wird, ohne daß sich die Speicherzellengröße bzw. Leitungsbreite und die schädliche Kapazität erhöht und ohne daß an die Peripherieschaltkreise besonders kritische Anforderungen in technischer Hinsicht gestellt werden müssen.

Die erfindungsgemäße Lösung besteht im Kennzeichen des Patentanspruchs 1. Nach dieser Lösung ist eine Bitleitungshälfte gleich einer Bitleitung im herkömmlichen Sinne. Damit ist eine Verdoppelung der Speicherzellen pro Verriegelungsschaltung erreicht.

Weitere Merkmale der Erfindung sind in den Patentansprüchen 2 bis 4 angegeben.

Durch die Aufteilung der Bitleitungen unter Verwendung einer zweiten Metallisierungsschicht für die Verdrahtung und der Selbstisolierungscharakteristiken der als Leseverstärker dienenden Verriegelungsschaltung wird eine Verdoppelung der Anzahl der Bits pro Verriegelungsschaltung erreicht, ohne daß die Zellgröße erhöht werden muß und ohne daß sich das Lesesignal unzulässig soweit verkleinert, daß ein größerer Aufwand in den

2

Peripherieschaltkreisen erforderlich wäre. Durch diese Maßnahmen wird insgesamt eine Einsparung bis zu 20 % an Halbleiterfläche auf einem Chip erzielt, und zwar ohne daß komplizierte Herstellungsverfahren dafür erforderlich sind.

Die Erfindung wird nun anhand eines in den Zeichnungen dargestellten Ausführungsbeispiels näher erklärt.

Es bedeuten:

Fig. 1 ein Prinzipschaltbild
Fig. 1A ein Impulsdiagramm und
Fig. 2 eine schematische perspektivische Darstelstellung der prinzipiellen Ausführung der Schaltung nach Fig. 1 in Mehrschichttechnik.

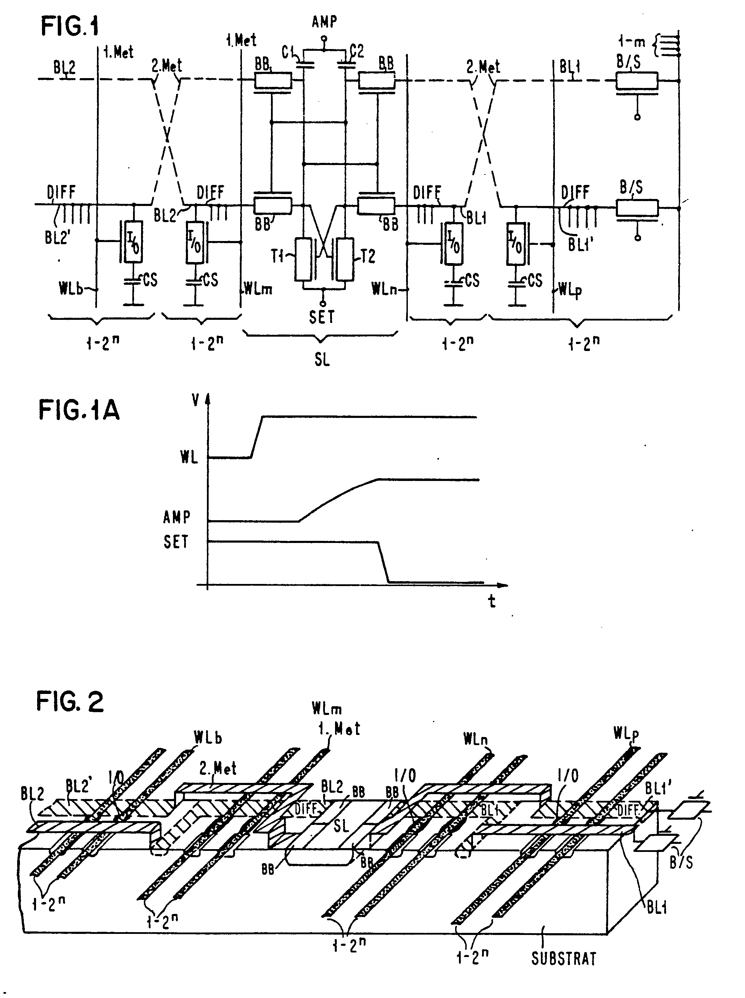

Das in Fig. 1 angegebene Prinzipschaltbild zeigt in der Mitte die Abfühlverriegelungsschaltung SL, die aus den kreuzgekoppelten Transistoren T1 und T2 sowie aus den vier die Eingänge der Abfühlverriegelungsschaltung bildenden Bitleitungskoppeltransistoren BB und den beiden Kapazitäten Cl und C2 besteht. Die Spannungsverläufe für die Anschlußpunkte AMP und SET sind in Abhängigkeit vom Potential auf der Wortleitung WL in Fig. la gezeigt. Es soll hier noch bemerkt werden, daß Abfühlverriegelungsschaltungen aus dem vorher im Stand der Technik genannten Material bekannt sind.

Sowohl mit dem linken als mit dem rechten oberen Bitleitungskoppeltransistor BB ist eine Leitung verbunden, die als zweite Metall-Leiterschicht ausgeführt ist und mit der als Bitleitungen BLI' bzw. BL2' dienenden Diffusionsschicht verbunden ist. Die unteren zwei Bitleitungskoppeltransistoren BB sind mit der Bitleitungshälfte BL1 bzw. BL2 verbunden, die als Diffusion ausgeführt sind. Mit diesen Bitleitungshälften BLI bzw. BL2 sind erste Gruppen von Speicherzellen verbunden, hier als Ein-FET-Speicherzellen ausgeführt und zwar mit jeweils einem Eingangstransistor I/O und einem Speicherkondensator CS, der mit seiner anderen Elektrode auf Masse liegt. Diese können über die Bitleitungen kreuzende Wortleitungen WLn bzw. WLm selektier werden. Die zweite Gruppe von Speicherzellen sowohl die Bitleitungshälfte BL1' als auch die Bitleitungshälfte BL2' wird über die Wortleitungen WLp bzw. WLb selektiert und ist mit der Diffusionsschicht verbunden, die über die zweite Metallschicht 2Met mit den jeweils oberen Bitleitungskoppeltransistoren BB der Abfühlverriegelungsschaltung SL verbunden sind. Die Bitleitungshälften BL1 bzw. BL1' sind, wie gezeigt, mit den Schaltern B/S an einer gemeinsamen Sammelleitung angeschlossen, an der noch weitere Bitleitungen 1 bis m liegen. Die Wortleitungen liegen hier in diesem Beispiel in der ersten Metalleiterschicht lMet.

Dadurch, daß die zweite Metalleiterschicht, mit der die zweiten Gruppen von Speicherzellen sowohl links als auch rechts mit der Abfühlverriegelungsschaltung SL verbunden sind, eine sehr niedrige Kapazität hat, und zusätzlich die Bitleitungskoppeltransistoren BB eingeführt worden sind, ist das Ausgangssignal beim Lesen einer Zelle nicht negativ beeinflußt und nur eine Abfühlverriegelungsschaltung ist somit für die doppelte Anzahl von Zellen im Vergleich zu den bisher bekannt gewordenen Lösungen erforderlich, ohne daß die Geschwindigkeit herabgesetzt wird. Außerdem ist es durch die erfindungsgemäße Anordnung möglich, daß ein Decoder jetzt die doppelte Anzahl von Speicherzellen bedient. Die Einführung der vier Bitleitungskoppeltransistoren BB in der Abfühlverriegelungsschaltung SL ermöglicht es außerdem daß jede Bitleitungshälfte während der Zeit AMP, unabhängig von der anderen Hälfte, angesteuert werden kann. d.h., daß die Speicherzellen in eine Hälfte unabhängig von Speicherzellen in der anderen Hälfte, gesetzt werden können. Jede Hälfte weist zum unabhängigen Setzen eigene nicht dargestellte Referenzzellen auf.

Anhand der Fig. 2 soll nun gezeigt werden, daß die Schaltungsanordnung nach Fig. 1 in einem Mehrschichtmetallprozeß tatsächlich ohne weiteres hergestellt werden kann. Zu diesem Zwecke ist eine perspektivische Darstellung eines mit zwei Metalleiterschichten lMet und 2Met versehenen Halbleiterkörpers gewählt worden. Im Substratblock ist in der Mitte die Abfühlverriegelungsschaltung SL mit den als Ladungskoppelungselementen ausgeführten Bitleitungskoppeltransistoren BB zu sehen. Aus dieser Darstellung sind klar die als Diffusion ausgeführten Bitleitungshälften BL1 und BL2 zu ersehen, die mit den oberen beiden kreuzgekoppelten Ladungskoppelementen BB (in Fig. 1 die unteren) verbunden sind. Diese beiden Diffusionsleitungen BLI und BL2 werden von Metalleitungen der ersten Schicht gekreuzt, die als Wortleitungen WL dienen. Diese beiden ersten Gruppen von Wortleitungen WLm und WLn werden nun ihrerseits von einer Metalleitung in der zweiten Metallschicht 2Met gekreuzt. Diese beiden Metalleitungen sind mit den unteren beiden als Ladungskopplungselemente ausgeführten Bitleitungskoppeltransistoren BB verbunden. Auf der anderen Seite sind diese beiden Metalleitungen mit den in der Diffusion befindlichen erweiterten Bitleitungshälften BL1' bzw. BL2' verbunden. Unter den Wortleitungen WL befindet sich wie aus Fig. 2 zu ersehen ist, der eigentliche Speicherkondensator CS und der Ein- und Ausgangstransistor I/O der Zellen. Es soll hier erwähnt sein, daß die Bezeichnungen der einzelnen Leitungen und Komponenten in Fig. 2 mit den entsprechenden in dem Schaltbild nach Fig. 1 übereinstimmen.

Die Zuführung der zu der als Diffusion ausgeführten Bitleitunshälfte BL1 zu den entsprechenden Bitschalter BS ist ebenfalls mit der zweiten Metalleiterschicht 2Met ausgeführt, die die Wortleitungen WLp senkrecht kreuzt. Der gleiche Sachverhalt trifft für die Verbindung der als Diffusion ausgeführten Bitleitungshälfte BL2 im linken Teil zu. Aus dieser Darstellung ist nocheinmal klar zu ersehen, daß durch die Verbindung der kreuzgekoppelten Bitleitungskoppeltransistoren BB, die als Ladungskopplungselemente ausgeführt sind, mit der Abfühlverriegelungsschaltung SL und durch die Verwendung der Diffusionsschicht und der zweiten Metallschicht als Bitleitungshälfte sowie der Verwendung der ersten Metallschicht als Wortleitung eine doppelte Anzahl von Speicherzellen an eine Abfühlverriegelungsschaltung und an einen Decoder angeschlossen werden kann, ohne daß sich die sonst störenden kapazitiven Einflüsse auf das Lesesignal auswirken und ohne daß die Speicherzelle wegen der sonst ungewollten kapazitiven Belastung vergrößert werden muß. Die Platzeinsparung

3

auf einem Halbleiterplättchen ist deshalb durch die erfindungsgemäße Anordnung beträchtlich.

**Patentansprüche**

1. FET-Speicher mit Abfühlverriegelungsschaltung (SL) zur Erhöhung der Anzahl von dynamischen FET-Speicherzellen, bei dem die Bitleitungen (BL1, BL2) beidseitig von je einem Eingang der Abfühlverriegelungsschaltung (SL) über die FET-Speicherzellen und über einen adressierbaren Bitschalter (B/S) zu Schreib-/Lesetreibern verlaufen, und die FET-Speicherzellen im Kreuzungspunkt zwischen den in einer Mehrfach-Metallschicht-Halbleiteranordnung angeordneten Bitleitungen (BL1, BL2) und senkrecht dazu verlaufenden Wortleitungen angeordnet sind, dadurch gekennzeichnet, daß jede Bitleitung (BLI, BL2) und ein an der Eingangsseite der Abfühlverriegelungsschaltung (SL) liegender Bitleitungskoppeltransistor (BB) doppelt ausgeführt sind, wodurch die entstandenen beiden Bitleitungshälften (BLI und BLI', B12 und BL2') voneinander isoliert sind, die Steuerelektroden und die der Abfühlverriegelungsschaltung (SL) zugewandten Elektroden der beiden Bitleitungskoppeltransistoren (BB) jeweils direkt und mit den entsprechenden Elektroden der beiden anderen Bitleitungskoppeltransistoren der gegenüberliegenden Seite der Abfühlverriegelungsschaltung (SL) kreuzgekoppelt verbunden sind, und daß jede der Bitleitungshälften zum unabhängigen Setzen der mit ihr verbundenen Speicherzellen eigene Referenzzellen aufweist.

2. FET-Speicher nach Anspruch 1, dadurch gekennzeichnet, daß ausgehend von den Bitleitungskoppeltransistoren (BB) ein erster Teil einer der beiden Hälften (BL1, B12) einer Bitleitung als Diffusionsschicht (DIFF) ausgeführt und mit einer ersten Gruppe von Speicherzellen verbunden ist, die über Wortleitungen (WLm bzw. Wln) selektiert werden, während der erste Teil der anderen Bitleitungshälfte (BL1', BL'2) als Metallschicht (2 Met) ausgeführt ist und daß nach Kreuzen der beiden Bitleitungshälften der zweite Teil der ersten Bitleitungshälfte (BL1, BL2) als Metallschicht (2 Met) ausgeführt ist, während der zweite Teil der zweiten Bitleitungshälfte (BL1', BL2') mit einer zweiten Gruppe von Speicherzellen verbunden ist, die über weitere Wortleitungen (Wlb bzw. Wlp) selektiert werden.

**Claims**

1. A FET storage with sense latch (SL) for increasing the number of dynamic FET storage cells, wherein the bit lines (BL1, BL2) extend on either side from one input each of the sense latch (SL) through the FET storage cells and an addressable bit switch (B/S) to read/ write drivers, and the FET storage cells are arranged at the crossing of the bit lines (BL1, BL2) in a multilayer metal semiconductor structure and word lines extending perpendicularly thereto, characterized in that each bit line (BL1, BL2) and a bit line coupling transistor (BB), positioned at the input side of the sense latch (SL), are provided in pairs so that the resultant two bit line halves (BL1 and BL1', BL2 and BL2') are isolated from each other, that the control electrodes and the electrodes of the two bit line coupling transistors (BB) facing the sense latch (SL) are in each case connected directly, in addition to being cross-coupled to the associated electrodes of the other two bit line coupling transistors of the opposite side of the sense latch (SL), and that each of the bit line halves has reference cells of its own for independently setting the storage cells connected thereto.

2. The FET storage according to claim 1, characterized in that extending away from the bit line couPling transistors (BB), a first section of one of the two halves (BL1, BL2) of a bit line is formed as diffusion layer (DIFF) and connected to a first group of storage cells which are selected by word lines (WLm and Wln, respectively), while the first section of the other bit line half (BL1', BL2') is formed as a metal layer (2 Met), and that after crossing of the two bit line halves, the second section of the first bit line half (BL1, BL2) is formed as a metal layer (2 Met), while the second section of the second bit line half (BL1', BL2') is connected to a second group of storage cells which are selected by further word lines (Wlb and Wlp, respectively).

**Revendications**

1. Mémoire à TEC comportant un circuit de verrouillage de détection (SL) servant à accroitre le nombre de cellules dynamiques de la mémoire à TEC, et dans laquelle les conducteurs de transmission de bits (BLI, BL2) s'étendent des deux côtés d'une entrée respective du dispositif de verrouillage de détection (SL) en circulant au-dessus des cellules de la mémoire à TEC et au-dessus d'un commutateur de bits adressable (D/S), jusqu'à des étages d'attaque d'enregistrement/lecture, et dans lequel les cellules de mémoire à TEC sont disposées au point d'intersection entre les conducteurs de transmission de bits (BL1, BL2), disposés dans un dispositif à semiconducteurs à couches métalliques multiples, et des lignes de transmission de mots s'étendant perpendiculairement aux lignes de transmission de bits, caractérisée en ce que chaque ligne de transmission de bits (BL1, BL2) et un transistor (BB) de couplage des lignes de transmission de bits, qui est situé sur le côté entrée du circuit de verrouillage de détection (SL), sont prévus en double, les deux moitiés obtenues des lignes de transmission de bits (BL1 et BL1' BL2 et BL2') étant isolées l'une de l'autre, que les électrodes de commande et les électrodes, tournées vers le circuit de verrouillage de détection (SL), des deux transistors (BB) de couplage des lignes de transmission de bits sont reliées respectivement directement et selon un couplage croisé aux électrodes correspondantes des deux autres transistors de couplage des lignes de transmission de bits du côté opposé du circuit de verrouillage de détection (SL), et que chacune des moitiés des lignes de transmission de bits comporte des cellules particuliéres de référence, pour réaliser le positionnement indépendant des cellules de mémoire, qui lui sont reliées.

2. Mémoire à TEC selon la revendication 1, caractérisée en ce que, à partir des transistors (BB) de couplage des lignes de transmission de bits, une premiére partie de deux moitiés (BLI, BL2) d'une ligne de transmission de bits est réalisée sous la forme d'une couche diffusée (DIFF) et est reliée à un premier groupe de cellules de mémoire qui sont sélectionnées par l'intermédiaire de lignes de transmission de mots (WLm ou WLn), tandis que la première partie de l'autre moitié des lignes de transmission de bits (BL1', BL2') est réalisée sous la forme d'une couche métallique (2 Met) et qu'après le croisement des deux moitiés des lignes de transmission de bits, la seconde partie de la première moitié (BLI, BL2) des lignes de transmission de bits est réalisée sous la forme d'une couche métallique (2 Met), tandis que la seconde partie de la seconde moitié des lignes de transmission de bits (BL1', BL2') est reliée à un second groupe de cellules de mémoire, qui sont sélectionnées par l'intermédiaire d'autres lignes de transmission de mots (Wlb ou Wlp).

# FIG.1

# FIG.1A

# FIG. 2